**Europäisches Patentamt**

**European Patent Office**

**Office européen des brevets**

(11) Numéro de publication : **0 353 121 B1**

(12) ## FASCICULE DE BREVET EUROPEEN

(45) Date de publication du fascicule du brevet :
**09.12.92 Bulletin 92/50**

(51) Int. Cl.$^5$ : **B41M 5/03, B41M 5/34, B41M 5/24, G03F 3/10**

(21) Numéro de dépôt : **89401983.5**

(22) Date de dépôt : **11.07.89**

(54) **Procédé d'impression polychrome par laser.**

(30) Priorité : **26.07.88 FR 8810052**

(43) Date de publication de la demande :
**31.01.90 Bulletin 90/05**

(45) Mention de la délivrance du brevet :
**09.12.92 Bulletin 92/50**

(84) Etats contractants désignés :
**AT BE CH DE ES GB GR LI NL SE**

(56) Documents cités :
**DE-A- 2 247 034**
**GB-A- 2 161 752**

(56) Documents cités :
**US-A- 3 682 635**
**PATENT ABSTRACTS OF JAPAN, vol. 8, no. 104 (M-296)[1541], 16 mai 1984; JP-A-59 14 993 (NIPPON DENSHI K.K.) 25-01-1984**

(73) Titulaire : **Breger, Guy**
**10 Chemin des Violettes**
**F-89100 Rosoy-Sens (FR)**

(72) Inventeur : **Breger, Guy**
**10 Chemin des Violettes**
**F-89100 Rosoy-Sens (FR)**

(74) Mandataire : **Cabinet Pierre HERRBURGER**
**115, Boulevard Haussmann**
**F-75008 Paris (FR)**

EP 0 353 121 B1

## Description

La présente invention concerne un procédé d'impression polychrome par laser.

Il est déjà connu d'utiliser le faisceau lumineux d'une source laser pour marquer des objets. Ce marquage est réalisé par évaporation ou fusion du matériau à la surface de l'objet. La surface ainsi traitée par le faisceau laser change de nuance ou de couleur. C'est ainsi que, par exemple, une surface de papier de couleur devient blanche à l'endroit de l'impact du faisceau laser.

Toutefois, on ne peut ainsi réaliser qu'une impression en "surimpression" en blanc.

Il existe, par ailleurs, de multiples procédés d'impression en couleur, par exemple des procédés photographiques, électrostatiques, des procédés utilisant des photo-polymères, des colorants, des jets d'encre ou des procédés thermiques.

Toutefois, aucun de ces procédés d'impression connus n'utilise des encres d'imprimerie ou des supports d'impression.

La présente invention a pour but de créer un procédé d'impression polychrome très simple et précis.

A cet effet, l'invention concerne un procédé du type ci-dessus, caractérisé en ce que :

- A) On réalise une feuille d'une première couleur à imprimer à l'aide d'un support provisoire que l'on recouvre de cette première couleur ;
- B) On détruit à l'aide d'un faisceau laser les parties de couleur de cette feuille de couleur à ne pas imprimer, pour ne laisser que les parties de couleur à imprimer de manière à constituer sur le support provisoire l'image de cette première couleur, image symétrique de l'image à imprimer ;
- C) On transfère avec repérage, cette image de cette première couleur sur le support définitif, par inversion ;
- D) On procède de la même manière selon les points A, B, C pour chacune des autres couleurs à imprimer.

Suivant une caractéristique particulièrement intéressante, après transfert de l'image d'une couleur sur le support définitif, déjà revêtu ou non d'autres images de couleur, on élimine le support provisoire.

Suivant une autre caractéristique de l'invention, les couleurs à imprimer sont les couleurs fondamentales complétées par le noir.

Le cas échéant, les couleurs ne sont pas limitées aux couleurs fondamentales et d'autres couleurs ou nuances de couleurs peuvent être utilisées suivant les besoins.

De façon particulièrement simple, les couleurs sont des encres d'imprimerie.

Il est particulièrement intéressant d'appliquer le procédé à des supports dits "définitifs", tels que des supports transparents ou opaques, du papier, des supports métalliques, des surfaces colorées, etc.

La présente invention sera décrite de manière plus détaillée à l'aide d'un exemple de mise en oeuvre du procédé selon l'invention, représenté aux dessins annexés dans lesquels :

- la figure 1 montre le point de départ du procédé de l'invention,
- la figure 2 montre les produits obtenus après le traitement des feuilles de couleur par un faisceau laser,
- la figure 3 montre le transfert d'une première feuille de couleur,
- la figure 4 montre le résultat du transfert d'une première couleur après élimination du support provisoire,
- la figure 5 montre le transfert de la seconde couleur sur le support définitif muni déjà de la première couleur,
- la figure 6 montre le résultat du transfert selon la figure 5 après enlèvement du support provisoire,
- la figure 7 montre le transfert de la troisième couleur,
- la figure 8 montre le résultat du transfert de la figure 7 après enlèvement du support provisoire de la troisième couleur,
- la figure 9 montre le transfert de la quatrième couleur,
- la figure 10 montre le résultat obtenu par les différentes opérations, selon les figures 1 à 9.

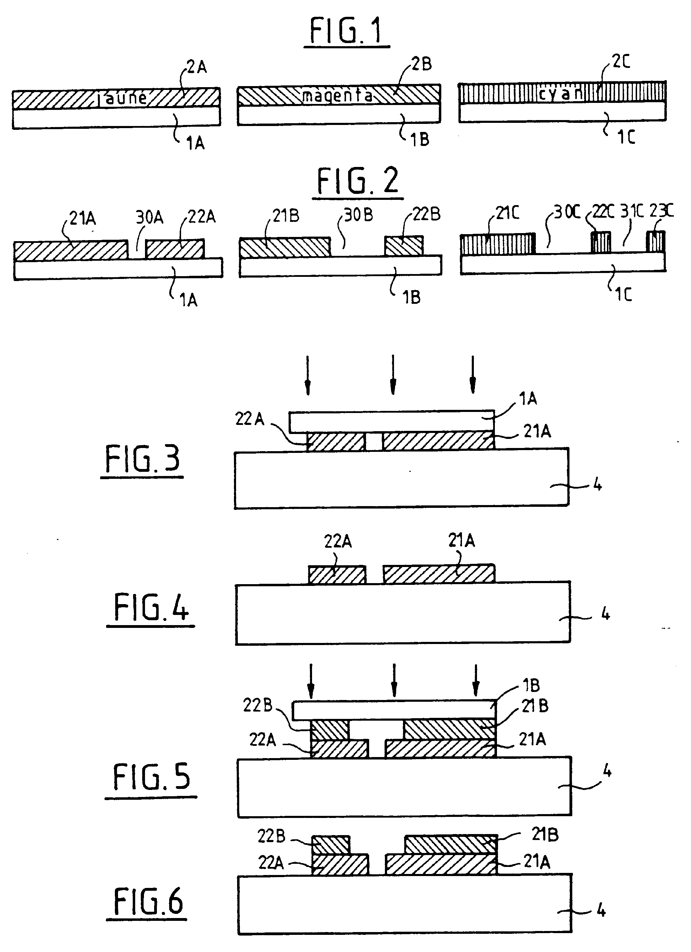

Selon le procédé de l'invention représentée aux figures 1 à 9, on réalise (figure 1) une feuille d'une première couleur à imprimer, cette feuille se composant d'un support provisoire 1A revêtu d'une première couleur 2A. On réalise de la même manière une feuille d'une seconde couleur se composant d'un support provisoire 1B revêtu d'une seconde couleur 2B ; on procède de la même manière pour réaliser une feuille d'une troisième couleur se composant d'un support provisoire 1C et d'une troisième couleur 2C.

Ces trois couleurs sont, par exemple, les couleurs fondamentales jaune, magenta, cyan ; il peut toutefois s'agir également d'autres couleurs.

De plus et suivant les usages dans l'impression, on réalise en général une feuille d'une quatrième couleur qui est, par exemple, le noir.

Cette feuille n'est pas représentée à la figure 1.

Les feuilles selon la figure 1 peuvent être réalisées au début du procédé selon l'invention ; il peut également s'agir de feuilles préparées à l'avance.

La figure 2 montre la seconde étape du procédé. Selon cette étape, à l'aide d'un faisceau laser, on reproduit sur chacune des feuilles de la figure 1 l'image de la couleur correspondante. Cela signifie qu'à l'aide du faisceau laser, on brûle les parties de la couche de couleur 2A, 2B ou 2C qui ne doivent pas être reproduites. Ainsi, schématiquement, sur le support provisoire 1A, il subsiste deux surfaces de couleur 21A, 22A et un intervalle brûlé 30A. Il en est de façon similaire pour les autres feuilles sur les supports provisoires 1B et 1C.

Les parties de couleur 21A, 22A, 21B, 22B, 21C, 22C, 23C qui subsistent sur les supports provisoires 1A, 1B, 1C correspondent à l'image de couleur obtenue, par exemple, par l'analyse de l'image modèle non représentée.

Cette analyse ne faisant pas partie de la présente invention et correspondant à des techniques et des installations connues, ne sera pas décrite ici.

Il est à remarquer que les surfaces de couleur 21A, 22A, 21B, 22B, 21C, 22C, 23C sont symétriques, planes des surfaces de couleur de l'image à réaliser, comme cela apparaîtra clairement ci-après.

Ainsi, selon la seconde étape du procédé, on détruit de la feuille les parties de couleur à ne pas imprimer à l'aide d'un faisceau laser, pour ne laisser subsister que les parties de couleur à imprimer constituant sur le support provisoire l'image de chacune des couleurs ; cette image est symétrique de l'image à imprimer.

La figure 3 montre la troisième étape du procédé.

Selon la figure 3, on transfère avec repérage l'image de la première couleur (support provisoire 1A, surface de couleur 21A, 22A) sur un support définitif 4 sur lequel on veut réaliser l'impression.

Ce transfert se fait par retournement, ce qui explique pourquoi l'image 21A, 22A doit être symétrique plane de l'image définitive à réaliser.

Selon la figure 4 qui représente la quatrième étape du procédé, on enlève le support provisoire 1A pour ne laisser sur le support définitif 4 que les surfaces de couleur 22A, 21A.

Selon la figure 5, on répète l'opération des figures 3 et 4 pour la deuxième image de couleur comprenant le support provisoire 1B et les surfaces de couleur 21B, 22B.

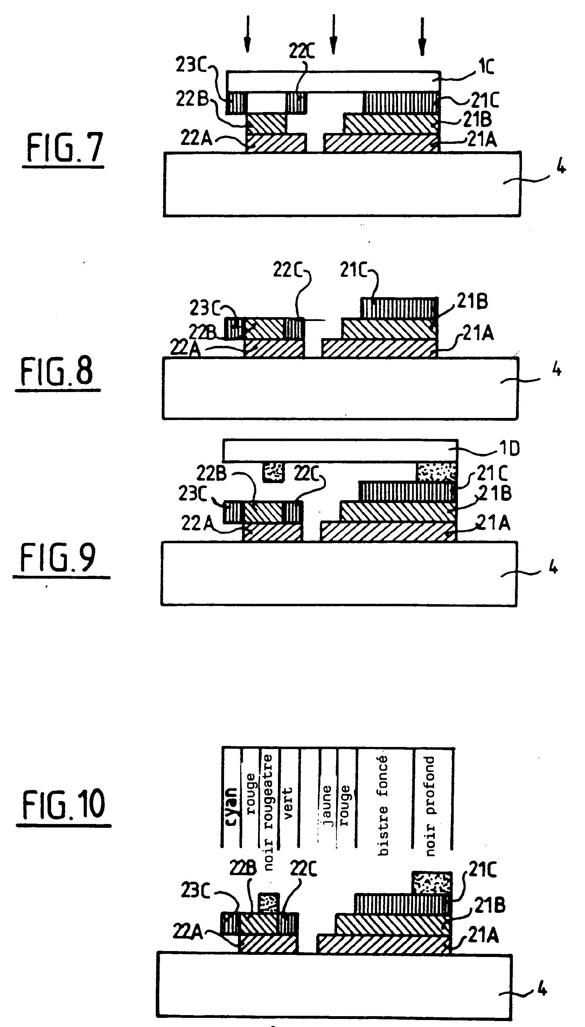

Selon les figures 7 et 8, on procède de la même manière pour la troisième feuille de couleur 1C, 2C comprenant le support provisoire 1C et les parties de couleur 21C, 22C, 23C.

Enfin, la figure 9 montre la dernière étape du procédé consistant au transfert de la quatrième couleur.

La figure 10 montre le résultat obtenu par la superposition des différentes couleurs.

Dans la partie supérieure de la figure 10, on n'a indiqué que les différentes couleurs dans le prolongement des parties correspondantes de couleur. On obtient ainsi du cyan, du rouge, du noir rougeâtre, du vert, du jaune, du rouge, une surface foncée et du noir profond.

Les caractéristiques du faisceau laser utilisé pour réaliser les images de couleur selon la figure 2, sont choisies en fonction de la nature des encres utilisées, de l'épaisseur des encres, etc.

De manière générale, le pinceau lumineux du laser est suffisamment concentré, précis et puissant pour ne laisser subsister que l'image constituée de points respectant une linéature définie, une dimension minimale de points correspondant à la qualité de l'image souhaitée.

La linéature la plus couramment utilisée est de 60 l/cm; d'autres linéatures sont possibles. Cette image de couleur présente des points encrés de dimensions variables, laissant apparaître des dégradés et des zones sans nuance avec ou sans ombres.

En fin de procédé on peut, suivant le cas, fixer les images sur le support définitif par des adhésifs à froid ou chaud de manière à assurer une bonne solidité de l'image définitive. Le transfert des images et leur fixation se font manuellement ou mécaniquement suivant la productivité souhaitée, la série à fabriquer, etc.

De la même manière, il est clair que, pour le transfert des différentes couleurs, on respecte un réparage précis, par exemple par tétonnage.

Le procédé selon l'invention est utilisable pour servir de sortie de couleur de tout traitement d'images informatiques, mais également pour fabriquer des épreuves réalisées à partir de films graphiques ou de contrôles et la création de forme imprimante avant le passage en imprimerie ou de circuit imprimé.

## Revendications

1. Procédé d'impression polychrome, caractérisé en ce que :
   - A) on réalise une feuille d'une première couleur à imprimer à l'aide d'un support provisoire (1A) que l'on recouvre de cette première couleur (2A),
   - B) on détruit à l'aide d'un faisceau laser les parties de couleur (30A) de cette feuille de couleur à ne pas imprimer, pour ne laisser que les parties de couleur à imprimer (21A, 22A) de manière à constituer sur le support provisoire (1A) l'image de cette première couleur, image symétrique de l'image à imprimer,
   - C) on transfère avec repérage, cette image de cette première couleur sur le support définitif (4) par inversion,
   - D) on procède de la même manière selon les points A, B, C pour chacune des autres couleurs (2B, 2C) à imprimer.

2. Procédé selon la revendication 1, caractérisé en ce qu'après transfert de l'image d'une couleur sur le support définitif, déjà revêtu ou non d'autres images de couleur, on élimine le support provisoire (1A, 1B, 1C).

3. Procédé selon la revendication 1, caractérisé en ce que les couleurs à imprimer sont les couleurs fondamentales complétées par le noir.

4. Procédé selon l'une quelconque des revendications 1 et 3, caractérisé en ce que les couleurs sont des encres d'imprimerie de couleurs variées.

5. Procédé selon la revendication 1, caractérisé en ce que le support (4) est un support transparent ou opaque, ou coloré ou métallisé.

**Patentansprüche**

1. Verfahren zum Mehrfarbendruck, gekennzeichnet durch folgende Verfahrensschritte:
   - A) man stellt ein Blatt mit einer ersten zu druckenden Farbe mit Hilfe eines Hilfsträgers (1A) bereit, der mit dieser ersten Farbe (2A) bedeckt ist,
   - B) man zerstört mit Hilfe eines Lasterstrahls die nicht zu druckenden Farbpartien (30A) dieses Farbblattes, so daß nur die zu druckenden Farbpartien (21A,22A) belassen werden, so daß auf dem Hilfsträger (1A) die Abbildung in dieser ersten Farbe spiegelbildlich zu der zu druckenden Abbildung hervorgerufen wird,
   - C) man überträgt unter Rapportfestlegung diese Abbildung in dieser ersten Farbe unter Umwendung auf den endgültigen Träger (4),
   - D) man geht in der gleichen Weise nach den Schritten A, B, C für jede der anderen zu druckenden Farben (2B,2C) vor.

2. Verfahren nach Anspruch 1, dadurch gekennzeichnet, daß man nach"der Übertragung der Abbildung in einer Farbe auf den endgültigen Träger, sei er nun schon mit anderen Farbabbildungen bedeckt oder nicht, den Hilfsträger (1A, 1B,1C) entfernt.

3. Verfahren nach Anspruch 1, dadurch gekennzeichnet, daß die zu druckenden Farben die Grundfarben sind, ergänzt durch Schwarz.

4. Verfahren nach einem der Ansprüche 1 bis 3, dadurch gekennzeichnet, daß die Farben Druckfarben in verschiedenen Farben sind.

5. Verfahren nach Anspruch 1, dadurch gekennzeichnet, daß der Träger (4) ein transparenter oder opaker, kolorierter oder metallisierter Träger ist.

**Claims**

1. A process of multicolour printing, characterised in that:
   - A) one sheet of a first colour to be printed is produced using a temporary support (1A) which is covered with this first colour (2A),
   - B) using a laser beam, the areas of the colour (30A) of this sheet of colour which are not to be printed are destroyed, so as to leave only the areas of colour which are to be printed (21A, 22A) in such a way as to form on the temporary support (1A) the image of said first colour, an image symmetrical with the image to be printed,
   - C) this image of this first colour is transferred with correct register onto the permanent support, by reversal,
   - D) the same process is carried out in accordance with points A, B, C for each of the other colours (2B, 2C) to be printed.

2. A process according to Claim 1, characterised in that after the transfer of the image of one colour onto the permanent support, which may or may not already have other colour images on it, the temporary support (1A, 1B, 1C) is removed.

3. A process according to Claim 1, characterised in that the colours to be printed are the primary colours with black in addition.

4. A process according to either of Claims 1 or 3, characterised in that the the colours are printing inks of various colours.

5. A process according to Claim 1, characterised in that the support (4) is a transparent or opaque, or coloured or metallized support.

FIG.1

FIG.2

FIG.3

FIG.4

FIG.5

FIG.6

FIG.7

23C
22C
1C
22B
21C
21B
22A
21A
4

FIG.8

23C
22C
21C
22B
21B
22A
21A
4

FIG.9

22B
22C
1D
23C
21C
21B
22A
21A
4

FIG.10

cyan
rouge
noir rougeatre
vert
jaune
rouge
bistre foncé
noir profond

23C
22B
22C
21C
22A
21B
21A
4